# EUROPEAN PATENT SPECIFICATION

(11) **EP 0 727 932 B1**
(45) Date of publication and mention of the grant of the patent: **07.04.1999**
(21) Application number: 95308494.4
(22) Date of filing: 27.11.1995
(51) Int. Cl.: H05K 9/00

(54) **Electromagnetic shielded casing**
Gehäuse mit elektromagnetischer Abschirmung
Boîtier avec blindage électromagnétique

(30) Priority: 28.11.1994 JP 292527/94; 25.07.1995 JP 187600/95
(43) Date of publication of application: 21.08.1996
(73) Proprietor: KABUSHIKI KAISHA TOSHIBA, Kawasaki-shi, Kanagawa-ken 210-8572 (JP)
(72) Inventor: Koike, Noboru, c/o Int. Prop. Div. Toshiba Corp., Tokyo (JP); Nakamura, Yutaka, c/o Int. Prop. Div. Toshiba Corp, Tokyo (JP)
(74) Representative: Shindler, Nigel

(56) References cited:
- DE-A- 2 032 408
- DE-U- 9 420 290
- US-A- 5 150 282

## Description

This invention is generally related to an electromagnetic shield structure for use in an electronic apparatus, and more particularly to a shield structure of reduced size and which lightens the electronic apparatus.

From US-A-5 150 282 there is known for example an electromagnetic shielding structure.

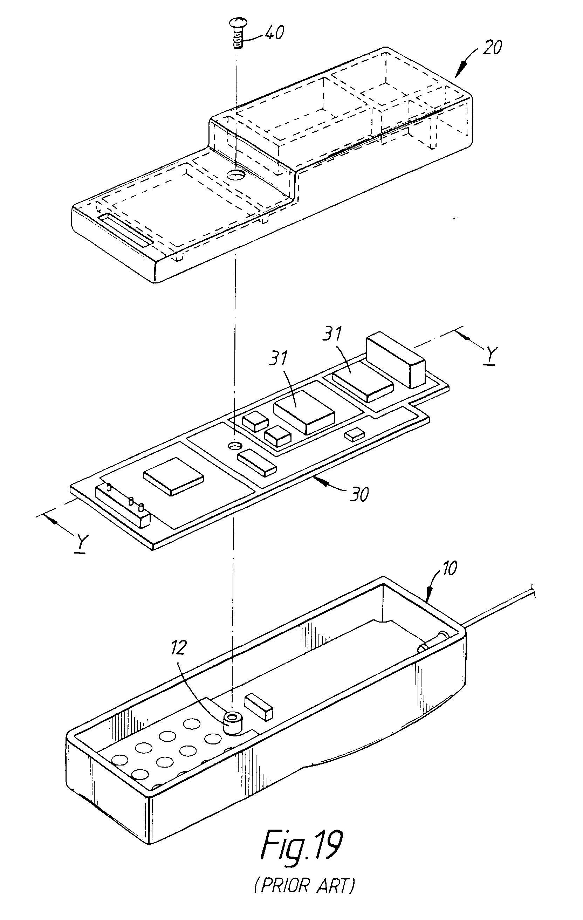

Referring to Figure 19, a conventional radio communication apparatus includes a first housing 10, a second housing 20, and a printed circuit board 30 (called PC board hereinafter). Many components 31 are mounted on the PC board 30. A screw 40 is fitted to a threaded socket 12, thereby the PC board 30 and the first housing are fitted to the second housing 20.

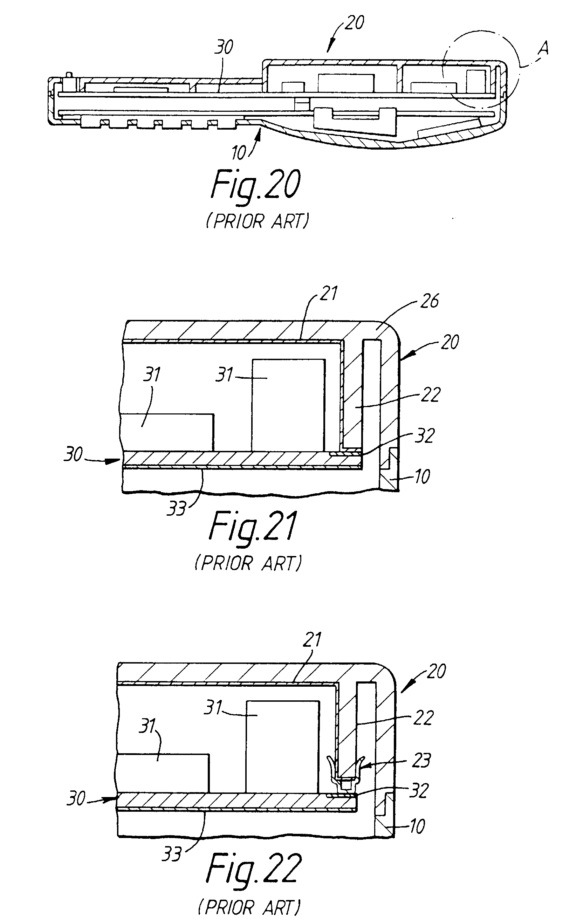

To electrically shield the components 31, various shield structures are used in conventional apparatus. Figure 20 shows apparatus using a conventional shield structure. A partial view illustrated by one dot line A is shown in Figure 21 and it will be seen that conductive layer 21 is plated on an inner surface of the second housing 20.

A first ground pattern 32 is printed on a surface of the PC board 30, while a second ground pattern 33 is printed on another surface of the PC board 30. The second housing 20 has a protruding portion 22.

When the first housing 10 and the PC board 30 are fitted to the second housing 20, the protruding portion 22 is urged toward the first ground pattern 32 and thereby contacts the first ground pattern 32. This structure enables the components 31 to be shielded by the conductive layer 21, the first ground pattern 32 and the second ground pattern 33.

Further, to enhance the connection between the conductive layer 21 and the first ground pattern 32, a conductive contact member 23 may be provided between the protruding portion 22 and the first ground pattern 32 as shown in Figure 22.

In the above conventional forms of apparatus, the second housing 20 includes a moulded resin member 26 and a conductive layer 21. The resin member 26 is formed by injection moulding and is then subjected to a conductive layer plating process. While the molded resin member 26 is being conveyed to the conductive layer plating process, it is necessary to treat the molded resin member 26 with great care so that it is not damaged.

Further, in the plating process, it is necessary to mask a predetermined area of the inner surface of the member 26 so that the conductive layer 21 is plated only onto regions other than the masked area. This involves another costly manufacturing step.

Furthermore, when the radio telecommunication apparatus comes to the end of its useful life, it is not easy to separate the conductive layer 21 from the resin member 26, and thus the materials are difficult to recycle.

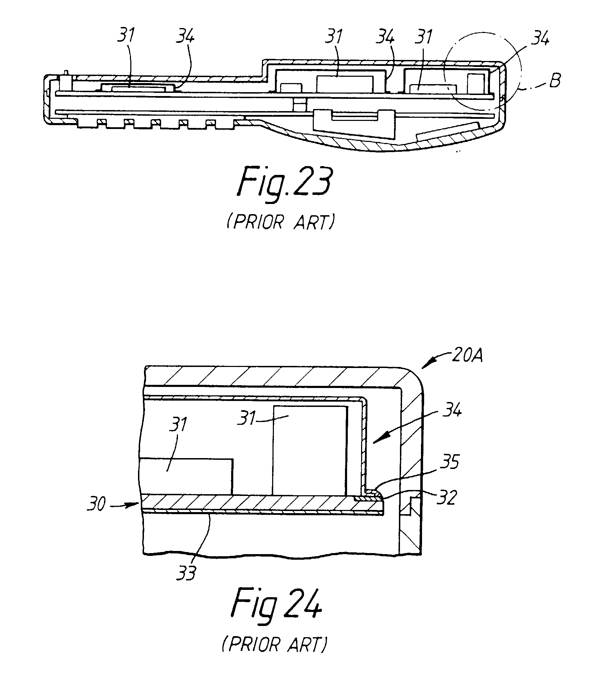

Another type of conventional structure is shown in Figure 23. A housing 20a is made of resin material. The components 31 are shielded by each of a plurality of conductive shield cases 34. A partial view illustrated by one dot lines B is shown in Figure 24. Each of the shield cases 34 is attached to the first ground pattern 32 on the PC board by soldering.

In this structure, an extra process is required to solder the shield case 34 to the PC board 30. Further, since extra space is needed between the shield case 34 and the housing 20a the apparatus becomes larger and heavier.

Accordingly, the present invention has been made in view of the above circumstances and seeks to provide an electronic apparatus which eliminates the need for plating a conductive layer on a housing surface of the electronic apparatus.

The present invention also seeks to provide an electronic apparatus having a housing which is suitable for recycling.

The present invention also seeks to provide a configuration for an electronic apparatus which reduces the amount of dead space in the housing and thereby reduces the size and the weight of the apparatus.

Accordingly the present invention as claimed provides a shield member for use in an electronic apparatus including a housing, the housing having a first locating means, the shield member being attached to a circuit board having a ground pattern and being characterised by:
a second locating means mating with the first locating means and a conductive layer, whereby, in use,
the shield member is clamped between the circuit board and the housing, and the conductive layer contacts the ground pattern.

The invention also extends to an electronic apparatus comprising, a circuit board having a ground pattern, components mounted on the circuit board, a housing including a first locating means and a shield member for shielding the components, having a second locating means mating with the first locating means and a conductive layer provided on the shield member, wherein the shield member is clamped between the circuit board and the housing, and the conductive layer contacts the ground pattern.

Some embodiments of the invention will now be described by way of example only with reference to the accompanying drawings in which:
Figure 1 is a perspective view illustrating a radio telecommunication apparatus according to a first embodiment of the present invention;
Figure 2 is a cross-sectional view taken along line X-X of Figure 1;
Figure 3 is a partial cross-sectional view illustrating a portion C of Figure 2;
Figure 4 is a partial cross-sectional view illustrating a portion D of Figure 2;
Figure 5 is a first step of a manufacturing process for a shield member;
Figure 6 is a second step of the manufacturing process;
Figure 7 is a table comprising properties of some materials;
Figure 8 is a perspective view illustrating a shield member according to a second embodiment;
Figure 9 is a partial cross-sectional view of the embodiment illustrated in Figure 8;
Figure 10 is a perspective view illustrating a shield member according to a third embodiment;
Figure 11 is a partial cross-sectional view illustrating the attachment state of the shield member according to the third embodiment;
Figure 12 is a perspective view illustrating a shield member according to a fourth embodiment;
Figure 13 is a partial cross-sectional view illustrating the mounting of the shield member according to the fourth embodiment;
Figure 14 is a perspective view illustrating a shield member according to a fifth embodiment;
Figure 15 is a partial cross-sectional view illustrating the mounting of the shield member according to the fifth embodiment;
Figure 16 is a partial cross-sectional view illustrating a shield member according to a sixth embodiment;
Figure 17 is a perspective view illustrating a manufacturing process in which a shield member according to a seventh embodiment is manufactured;
Figure 18 is a perspective view illustrating a manufacturing process in which a shield member according to an eighth embodiment is manufactured;
Figure 19 is a perspective view illustrating a first conventional radio telecommunication apparatus;
Figure 20 is a cross-sectional view taken along line Y-Y of Figure 19;
Figure 21 is a partial cross-sectional view illustrating a portion A of Figure 20;
Figure 22 is a partial cross-sectional view illustrating a second conventional apparatus;
Figure 23 is a cross-sectional view illustrating a third conventional apparatus including a third conventional structure; and
Figure 24 is a partial cross-sectional view illustrating a portion B of Figure 23.

Referring to the drawings,

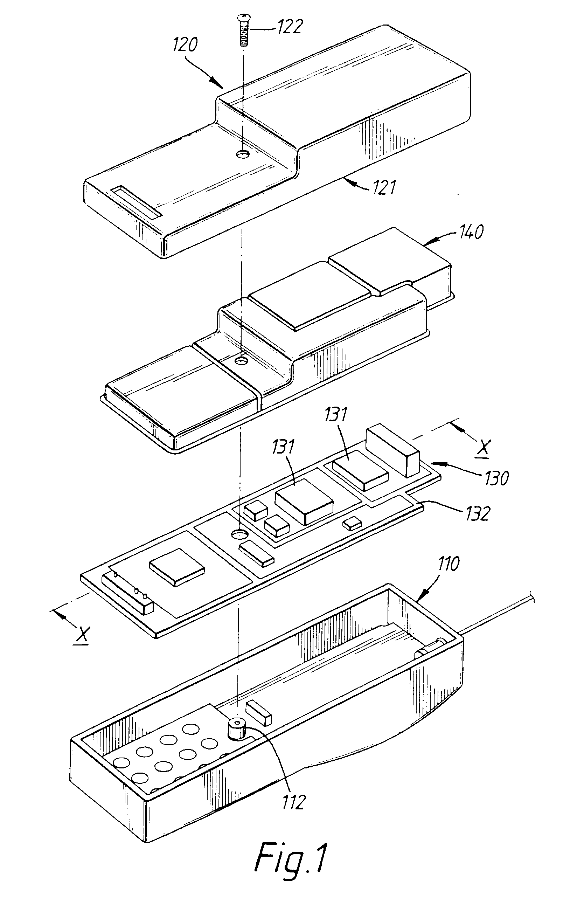

Figure 1 shows a radio telecommunication apparatus (referred to hereinafter as an apparatus) including a shield structure of the present invention.

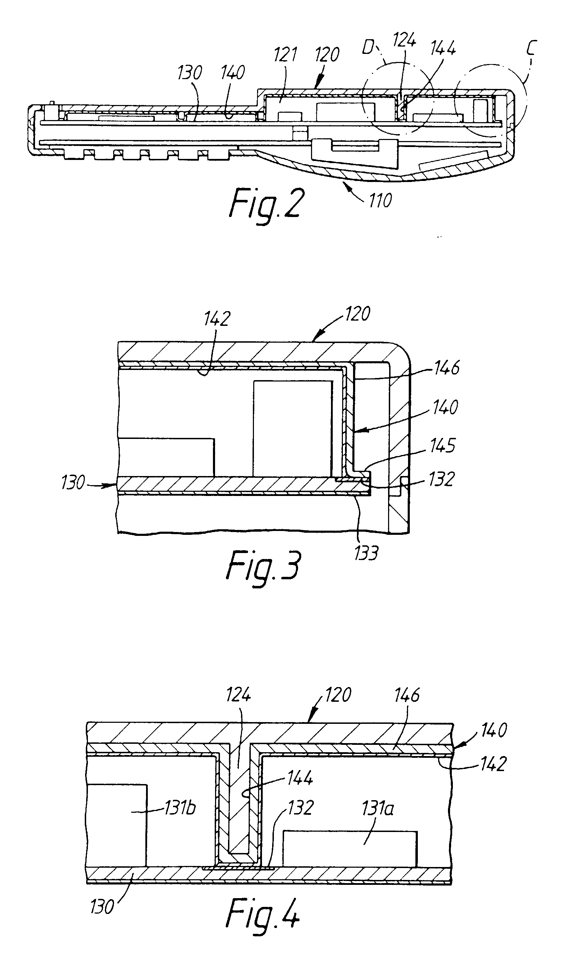

The apparatus includes a first housing 110, a second housing 120 with a space 121, a PC board 130 and a shield case 140 mating with the space 121 for shielding components 131 mounted on the PC board 130. A ground pattern 132 is printed on the PC board 130. The first housing 110 is fitted to the second housing 120 by a male screw 122 and female screw 112 mating with the male screw 122. This structure is illustrated in Figure 2 in detail which is a cross-sectional view taken along line X-X.

Referring to Figure 2, the second housing 120 has a protruding portion 124 as a first location determination portion. The shield case 140 includes a groove portion 144 mating with the protruding portion 12. The groove portion 144 serves as a second location determination portion. Since the groove portion mates with the protruding portion, the shield case 140 is located at a predetermined area of the second housing 120.

A first partial structure illustrated by one dot line C is shown in Figure 3, while a second partial structure illustrated by one dot line D is shown in Figure 4. Referring to Figure 3, the shield case 140 includes a resin member 146 and a conductive layer 142 plated on an inner surface of the resin member 146. When the shield case 140 is clamped between the circuit board 130 and the second housing 120 by the male and female screws as shown in Figure 1, the shield case 140 is urged toward the PC board 130. Therefore, the conductive layer 142 contacts the first ground pattern 132.

Referring to Figure 4, the groove portion 144 mates with the protruding portion 124. Thereby the shield case 140 is located at a predetermined area of the second housing 120. Further, the conductive layer 142 on the groove portion 144 contacts the first ground pattern 132. Therefore, the groove portion 144 serves as a wall for isolating a component 131a and a component 131b, and for dividing the space enclosed by the shield case 140 and the PC board 130, into a plurality of space.

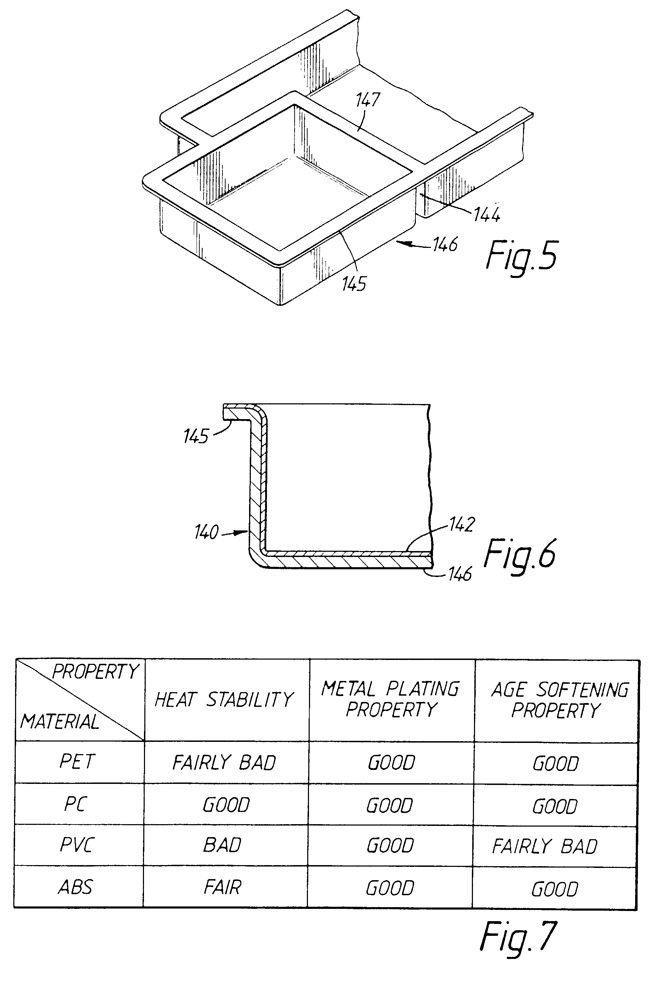

The shield case 140 is made by the following process illustrated by Figures 5 and 6. In a first step illustrated by Figure 5, a resin member is formed by resin injection moulding so that the deformed resin member 146 mates with the protruding portion 124 and the space 121 of the second housing 120. In a second step, the conductive layer 142 is plated in the inner surface of the resin member 146, a flange portion 145 of the shield case 140 and the other surface 147 of the groove portion 144.

The resin member 146 has 0.15mm - 0.25mm thickness and approximately 0.6g weight. The housing has 1mm - 2.5mm thickness and approximately 1.5g weight. Therefore, the resin member 146 is much thinner than the second housing 120 and much lighter than the second housing 120.

It will be appreciated that various forming processes may be used such as vacuum forming, plug assist forming, or injection moulding with vacuum which assists fluid resin flow in a mould.

The resin member 146 may be made of polyester resin, ("PET"), polycarbonate ("PC"), polyvinyl chloride ("PVC") or ABS (acrylonitrile butadiene styrene). Relevant properties of each of these materials are compared in Figure 7. This shows that PC and ABS are most suitable for the resin member 146 having regard to heat suitability and age softening. PC is widely used and cheaper and therefore preferable to ABS

The conductive layer 142 is plated on the inner surface of the resin member 146. However, the conductive layer 142 may be provided on the resin member 146 by other methods well known in the art, such as painting, sputtering, ion plating, evapolated metal attaching method which attaches evapolated metal to a resin object in vacuum air.

The conductive layer 142 includes Ni(Nickel), Cu(Copper). The conductive layer 142 may include Au(Gold), Ag(silver). Further, the conductive layer 142 has 1µm-3µm thickness.

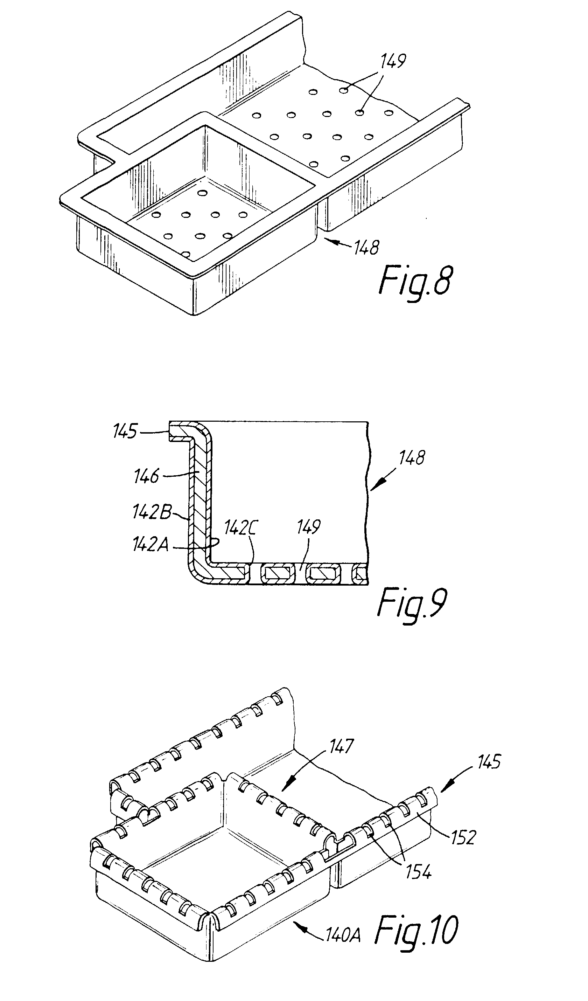

Although the conductive layer 142 is provided on the inner surface of the resin member 146, the conductive layer may be provided on the outer surface of the resin member 146 as shown in Figures 8 and 9. A shield case 148 includes holes 149. A conductive layer 142C is also provided on an inner surface of the holes 149. Thereby, the conductive layer 142B on the outer surface is connected with the conductive layer 142A on the inner surface via the conductive layer 142C on the holes 149. The holes have a wavelength/50 pitch, where the apparatus communicates signals with a base station over a radio channel having the wavelength. In this state, electromagnetic signals are not inserted into the shield case 148 via the holes 149, and the components in the shield case 148 does not radiate electromagnetic signals outside.

In this arrangement, the shielding efficiency of the shield case 148 of this structure is about the same as the conventional structure with the conductive shield case having the same thickness as that of the shield case 148.

As mentioned above, the shield case 140 mates with the space 121 of the second housing 120 and the protruding portion 124 and is clamped by the PC board 130 and the second housing 120 when the first housing 110 is fitted to the second housing 120 by the male and female threaded members 112 and 122. Therefore, deadspace between the second housing 120 and the shield case 140 is eliminated.

Further, it is unnecessary to place a conductive layer on the housing.

Furthermore when the screw 122 is removed from the threaded socket 112, the shield case 140 is separated from the housing 120. Therefore, it is easy to dispose of the second housing 120 without the conductive layer. Therefore, this structure is suitable for disposal and recycle of resin material.

The shield case is urged toward the PC board by the screw connection and is very thin, and the flange portion 145 and the other surface 147 of the groove portion 144 are very flexible. Therefore, it is unnecessary to solder the shield case to the PC board like the conventional structure. Further, the shield case 140 is firmly connected with the first ground pattern 132 by the resilience of the flange portion 145 and the other surface 147 of the groove portion 144.

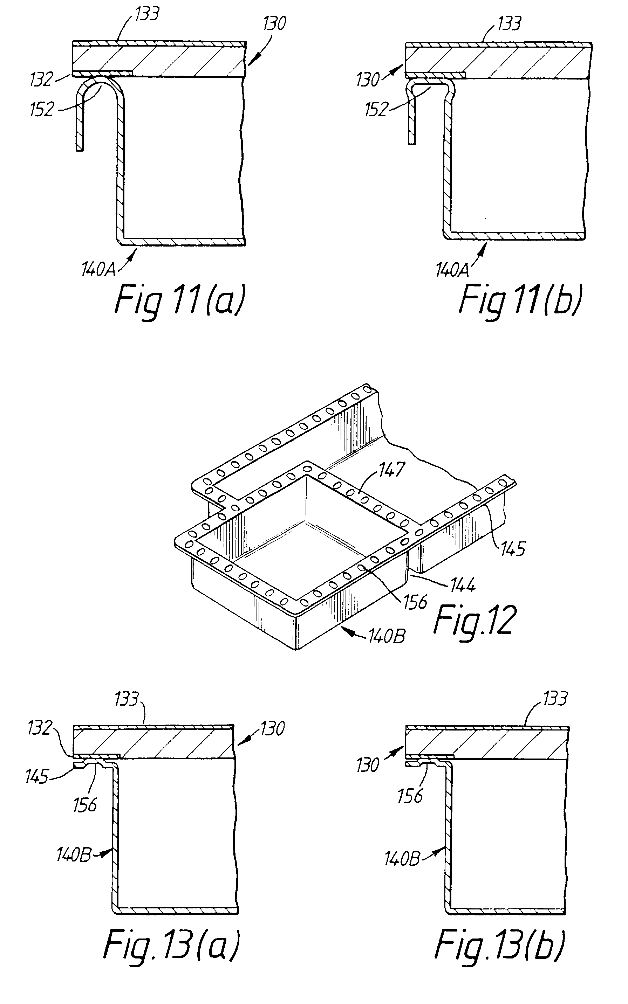

The flange portion 145 and the other surface 147 of the groove portion 144 may have other structures as shown in Figure 10. The flange portion 145 and the other surface 147 of the groove portion 144 have tongues 152 and grooves 154. When the first housing is fitted to the second housing, the tongue 152, as shown in Figure 11a, is urged towards the PC board 130, and thereby is deformed as shown in Figure 11b. This structure enhances the connection between the shield case 140a and the ground pattern 132 on the PC board 130. When the first housing is removed from the second housing, the shape of the tongue 152 becomes the initiate shape as shown in Figure 11a by elasticity of the tongue 152.

Further, the flange portion 145 and the other surface 147 of the groove portion 144 may have hemispheres as shown in Figure 12. A shield case 140b has a plurality of hemispheres 156 on the flange portion 145 and the other surface 147 of the groove portion 144. Each of the hemispheres 156 is arranged with a predetermined separation distance and has elasticity. When the first housing is fitted to the second housing, hemisphere 156 as shown in Figure 13a is urged toward the PC board 130, and is thereby deformed as shown in Figure 13b. This structure enhances the connection between the shield case 140b and the ground pattern 132 on the PC board 130. When the first housing is removed from the second housing, the hemisphere 156 returns to its initial shape as shown in Figure 13a.

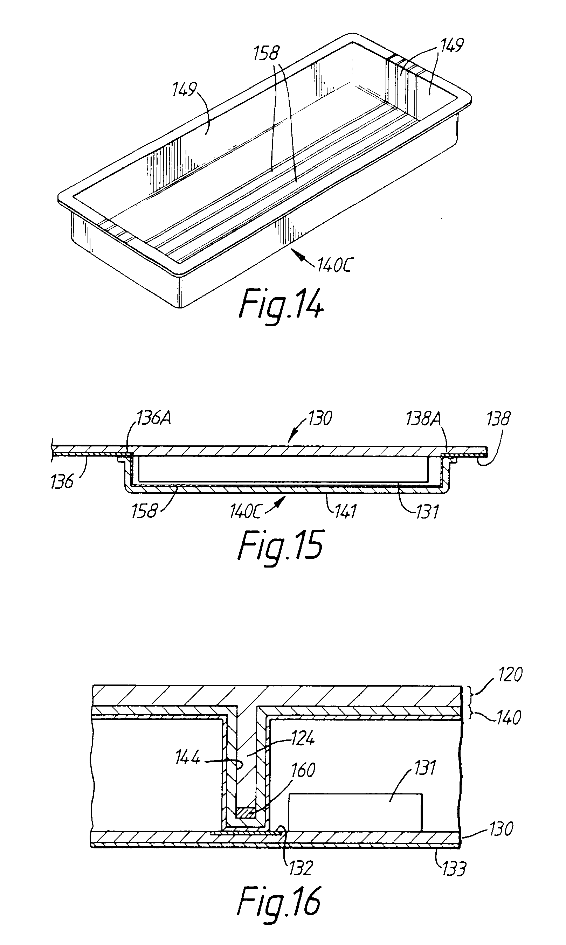

Although only the conductive layer for shielding the components is provided on the shield case in the above embodiment, another conductive material separated from the conductive layer may be provided on the shield case. Referring to Figures 14 and 15, a shield case 140°C has a first conductive layer 140 for shielding the components and a second conductive layer 158 for connecting a first signal pattern 136 with a second signal pattern 138. The second conductive layer 158 is connected with a first land 136a coupled to the first signal pattern 136 and a second land 138a coupled to the second signal pattern 138.

In this arrangement, the shield case 140c shields the components 131 and also connects the first signal pattern 136 and the second signal patter 138.

Further, to enhance the connection between the conductive layer 142 and the first ground pattern 132, as shown in Figure 16, an elastic member 160 such as a foamed material may be arranged between the protruding portion 124 of the second housing 120 and the groove portion 144 of the shield case 140.

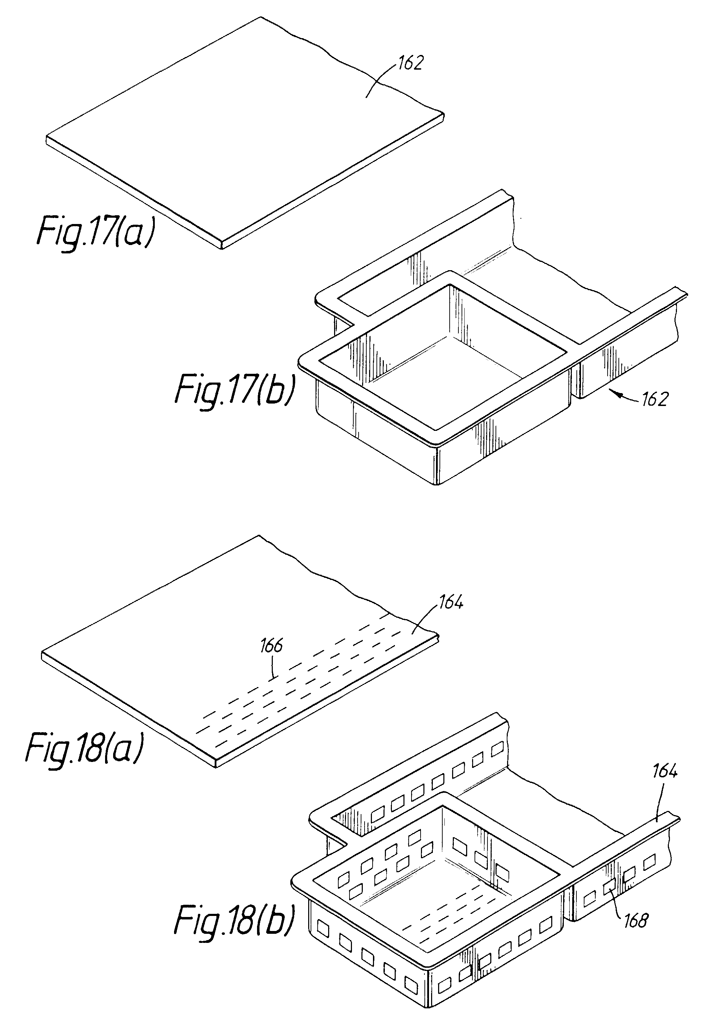

Furthermore, as shown in Figure 5, in the above embodiments, the resin is formed by an injection moulding method so that the resin member 146 mates with the second housing. After that, the conductive layer 142 is provided on the resin member 146. Alternatively, a metal plate may be formed as shown in Figure 17. A metal plate 162 as shown in Figure 17a such as copper plated with nickel is deformed by a well known method such as plastic deformation so that the formed metal plate 162 mates with the second housing as shown in Figure 17b. The metal plate 162 is 0.1mm thickness.

Although the metal plate is deformed in the above embodiment, the resin plate plated with a conductive layer such as nickel and copper may be deformed by the plastic deformation.

Further, to facilitate the plastic deformation of the plate, a plurality of slits 166 may be provided at the plate as shown in Figure 18. A metal plate 164 has a plurality of slits 166 as shown in Figure 18a. After the plastic deformation of the plate 164, the slits 166 becomes holes 168 Figure 18b. Therefore, the structure facilitates the plastic deformation.

In this arrangement, each hole 168 has a pitch of λ\50, where the apparatus communicates with a base station over a radio channel having the wavelengthλ. Therefore, electromagnetic signals cannot penetrate the shield case via the holes, and the components in the shield case do not radiate electromagnetic signals outside.

Further, although these embodiments of the present invention are used in a radio telecommunication apparatus, these embodiments may be used in other electronic apparatus having components to be shielded.

Furthermore, referring to Figure 4, although the protruding portion 124 serves as a first locating means and the grooved portion 144 serves as a second location means, their positions may of course be interchanged.

Further, referring to Figures 10 and 12, although the flange portion 145 and the other surface 147 of the groove portion 144 are provided with tongues 152 and hemispheres 156, the flange portion 145 and the other surface 147 of the groove portion 144 may be deformed in advance so that they have portions curved toward the PC board which provide resilience.

The foregoing description of preferred embodiments of the invention has been presented for purposes of illustration and description. It is not intended to be exhaustive or to limit the invention to the precise form disclosed, and modifications and variations are possible in the light of the above teachings or may be acquired from practice of the invention. The embodiments were chosen and described in order to explain the principles of the invention and its practical application to enable one skilled in the art to utilise the invention in various embodiments and with various modifications as are suited to the particular use contemplated. It is intended that the scope of the invention be limited only by the appended claims.

## Claims

1. A shield member for use in an electronic apparatus including a housing (120), the housing (120) having a first locating means (124), the shield member (140, 140A, 140B, 140C, 148, 162, 164) being attached to a circuit board (130) having a ground pattern (132) and being characterised by:
a second locating means (144) mating with the first locating means (124) and a conductive layer (142, 142A, 142B, 142C, 149), whereby, in use,
the shield member (140, 140A, 140B, 140C, 148, 162, 164) is clamped between the circuit board (130) and the housing (120), and the conductive layer (142, 142A, 142B, 142C, 149) contacts the ground pattern (132).

2. A shield member according to claim 1, further characterised by comprising a resin member (146) including the second locating means (144) and the conductive layer (142, 142A, 142B, 142C, 149) provided on an inner surface of the resin member (146).

3. A shield member according to claim 2, further characterised in that the resin member (146) is made of polycarbonate.

4. A shield member according to claim 2, further characterised by a wall (144) which is arranged to divide the space between the shield member (140, 140A, 140B, 140C, 148, 162, 164) and the circuit board (130).

5. A shield member according to claim 4, further characterised in that the wall (144) comprises the second locating means (144).

6. A shield member according to any of claims 1 to 5, further characterised by a contact portion (145, 147) contacting the ground pattern (132).

7. A shield member according to claim 6, further characterised in that the contact portion (145, 147) is resilient so as to enhance the contact between the shield case (140, 140A, 140B, 140C, 148, 162, 164) and the ground pattern (132).

8. A shield member according to any of claims 1 to 7, further characterised by a connection track (158) for electrically connecting first and second signal lines (136, 138) on the circuit board (130), the connection track (158) being separated from the conductive layer (149).

9. A shield member according to any of claims 1 to 8, further characterised by resilient member (160) provided between the first locating means (124) and the shield member (140).

10. An electronic apparatus characterised by:
a circuit board (130) having a ground pattern (132);
components (131) mounted on the circuit board (130);
a housing (120) including first locating means (124);
and a shield member according to any preceding claim,
wherein the shield member (140, 140A, 140B, 140C, 148, 162, 164) is clamped between the circuit board (130) and the housing (120), and the conductive layer (142, 142A, 142B, 142C, 149) contacts the ground pattern (132).

11. Apparatus according to claim 10 in which the first locating means comprises a projecting member and the second locating means comprises a co-operating recess.

12. A method of manufacturing a shield member (140, 140A, 140B, 140C, 148) according to any of claims 1 to 9, for use in an electronic apparatus enclosed in a housing (120), the housing (120) having a first locating means (124), the shield member (140, 140A, 140B, 140C, 148) being attached to a circuit board (130) having a ground pattern (132) and contacting the ground pattern (132), characterised by the steps of:
deforming a resin member to form a second locating means (144) for engagement with the first locating means determination portion (124); and
providing a conductive layer (142, 142A, 142B, 142C, 149) on surface of the deformed resin member (146).

13. A method according to claim 12, further characterised in that the step of deforming is performed by injection moulding.

14. A method of manufacturing a shield member (162, 164) according to any of claims 1 to 9, for use in an electronic apparatus enclosed in a housing (120), the housing (120) having a first locating means (124), the shield member (162, 164) being attached to a circuit board (130) having a ground pattern (132) and a contacting the ground pattern (132), characterised by the steps of:
deforming a conductive member (162, 164) so that the deformed conductive member (162, 164) has a second locating means (144) mating with the first locating means (124) by a plastic deformation method.

## Patentansprüche

1. Abschirmelement zur Verwendung in einem elektronischen Gerät mit einem Gehäuse (120) mit einer ersten Verrastung (124), wobei das Abschirmelement (140, 140A, 140B, 140C, 148, 162, 164) an einer Schaltungsplatte (130) mit einem Erdungsmuster (132) angebracht ist und gekennzeichnet ist durch
eine zweite Verrastung (144), die mit der ersten Verrastung (124) und einer leitfähigen Schicht (142, 142A, 142B, 142C, 149) zusammenpaßt, wodurch
das Abschirmelement (140, 140A, 140B, 140C, 148, 152, 164) bei der Benutzung zwischen der Schaltungsplatte (130) und dem Gehäuse (120) geklemmt wird und die leitfähige Schicht (142, 142A, 142B, 142C, 149) mit dem Erdungsmuster (132) in Kontakt ist.

2. Abschirmelement nach Anspruch 1, ferner dadurch gekennzeichnet, daß es ein Harzelement (146) einschließlich der zweiten Verrastung (144) umfaßt, wobei die leitfähige Schicht (142, 142A, 142B, 142C, 149) auf der Innenfläche des Harzelements (146) vorgesehen ist.

3. Abschirmelement nach Anspruch 2, ferner dadurch gekennzeichnet, daß das Harzelement (146) aus Polycarbonat hergestellt ist.

4. Abschirmelement nach Anspruch 2, ferner gekennzeichnet durch eine Wandung (144), die zur Unterteilung des Raums zwischen dem Abschirmelement (140, 140A, 140B, 140C, 148, 162, 164) und der Schaltungsplatte (130) eingerichtet ist.

5. Abschirmelement nach Anspruch 4, ferner dadurch gekennzeichnet, daß die Wandung (144) die zweite Verrastung (144) aufweist.

6. Abschirmelement nach einem der Ansprüche 1 bis 5, ferner gekennzeichnet durch einen Kontaktteil (145, 147), der das Erdungsmuster (132) kontaktiert.

7. Abschirmelement nach Anspruch 6, ferner dadurch gekennzeichnet, daß der Kontaktteil (145, 147) nachgiebig ist, so daß der Kontakt zwischen dem Abschirmgehäuse (140, 140A, 140B, 140C, 148, 162, 164) und dem Erdungsmuster (132) erhöht wird.

8. Abschirmelement nach einem der Ansprüche 1 bis 7, ferner gekennzeichnet durch eine Anschlußspur (158) für den elektrischen Anschluß einer ersten und zweiten Signalleitung (136, 138) an der Schaltungsplatte (130), wobei die Anschlußspur (158) von der leitfähigen Schicht (149) getrennt ist.

9. Abschirmelement nach einem der Ansprüche 1 bis 8, gekennzeichnet ferner durch ein Federelement (160), das zwischen der ersten Verrastung (124) und dem Abschirmelement (140) vorgesehen ist.

10. Elektronisches Gerät, gekennzeichnet durch
eine Schaltungsplatte (130) mit einem Erdungsmuster (132),
auf der Schaltungsplatte (130) angebrachte Komponenten (131),
ein Gehäuse (120) mit einer ersten Verrastung (124) und einem Abschirmelement nach einem vorhergehenden Anspruch,
wobei das Abschirmelement (140, 140A, 140B, 140C, 148, 162, 164) zwischen die Schaltungsplatte (130) und das Gehäuse (120) geklemmt ist und die leitfähige Schicht (142, 142A, 142B, 142C, 149) das Erdungsmuster (132) kontaktiert.

11. Gerät nach Anspruch 10, bei dem die erste Verrastung ein vorspringendes Element und die zweite Verrastung eine mit ihm zusammenwirkende Aussparung umfaßt.

12. Verfahren zur Herstellung eines Abschirmelements (140, 140A, 140B, 140C, 148) nach einem der Ansprüche 1 bis 9, zur Verwendung in einem in einem Gehäuse (120) enthaltenen elektronischen Gerät, wobei das Gehäuse (120) eine erste Verrastung (124) hat, das Abschirmelement (140, 140A, 140B, 140C, 148) an einer Schaltungsplatte (130) mit einem Erdungsmuster (132) angebracht ist und das Erdungsmuster (132) kontaktiert, gekennzeichnet durch die Stufen der
Verformung eines Harzelements zur Bildung einer zweiten Verrastung (144) für den Eingriff mit dem Bestimmungsteil (124) der ersten Verrastung, und
Schaffung einer leitfähigen Schicht (142, 142A, 142B, 142C, 149) auf der Oberfläche des verformten Harzelements (146).

13. Verfahren nach Anspruch 12, dadurch gekennzeichnet, daß man die Stufe der Verformung durch Spritzgießen durchführt.

14. Verfahren zur Herstellung eines Abschirmelements (162, 164) nach einem der Ansprüche 1 bis 9, zur Verwendung in einem in einem Gehäuse (120) enthaltenen elektronischen Gerät, wobei das Gehäuse (120) eine erste Verrastung (124) hat, das Abschirmelement (162, 164) an einer Schaltungsplatte (130) mit einem Erdungsmuster (132) angebracht ist und das Erdungsmuster (132) kontaktiert, gekennzeichnet durch die Stufe der
Verformung eines leitfähigen Elements (162, 164), so daß das verformte leitfähige Element (162, 164) eine zweite Verrastung (144) aufweist, die mit der durch ein plastisches Verformungsverfahren gebildete erste Verrastung (124) zusammenpaßt.

## Revendications

1. Elément de blindage à utiliser dans un appareil électronique comprenant un boîtier (120), le boîtier (120) présentant des premiers moyens de positionnement (124), l'élément de blindage (140, 140A, 140B, 140C, 148, 162, 164) étant fixé à une carte de circuit (130) ayant un motif de base (132) et étant caractérisé par :
des deuxièmes moyens de positionnement (144) couplés aux premiers moyens de positionnement (124) et une couche conductrice (142, 142A, 142B, 142C, 149) de telle sorte que, en utilisation,
l'élément de blindage (140, 140A, 140B, 140C, 148, 162, 164) est serré entre la carte de circuit (130) et le boîtier (120) et la couche conductrice (142, 142A, 142B, 142C, 149) vient en contact avec le motif de base (132).

2. Elément de blindage selon la revendication 1, caractérisé en outre en ce qu'il comprend un élément en résine (146) comprenant les deuxièmes moyens de positionnement (144) et la couche conductrice (142, 142A, 142B, 142C, 149) prévus sur une surface intérieure de l'élément en résine (146).

3. Elément de blindage selon la revendication 2, caractérisé en outre en ce que l'élément en résine (146) est fait en polycarbonate.

4. Elément de blindage selon la revendication 2, caractérisé en outre par une paroi (144) qui est agencée pour diviser l'espace entre l'élément de blindage (140, 140A, 140B, 140C, 148, 162, 164) et la carte de circuit (130).

5. Elément de blindage selon la revendication 4, caractérisé en outre en ce que la paroi (144) comprend les deuxièmes moyens de positionnement (144).

6. Elément de blindage selon l'une quelconque des revendications 1 à 5, caractérisé en outre par une partie de contact (145, 147) venant en contact avec le motif de base (132).

7. Elément de blindage selon la revendication 6, caractérisé en outre en ce que la partie de contact (145, 147) est élastique de manière à augmenter le contact entre le boîtier de blindage (140, 140A, 140B, 140C, 148, 162, 164) et le motif de base (132).

8. Elément de blindage selon l'une quelconque des revendications 1 à 7, caractérisé en outre par une piste de connexion (158) pour connecter électriquement des première et deuxième lignes de signal (136, 138) sur la carte de circuit (130), la piste de connexion (158) étant séparée de la couche conductrice (149).

9. Elément de blindage selon l'une quelconque des revendications 1 à 8, caractérisé en outre par un élément résilient (160) prévu entre les premiers moyens de positionnement (124) et l'élément de blindage (140).

10. Appareil électronique caractérisé par :
une carte de circuit (130) possédant un motif de base (132) ;
des composants (131) montés sur la carte de circuit (130) ;
un boîtier (120) comprenant des premiers moyens de positionnement (124) et un élément de blindage selon l'une quelconque des revendications précédentes,
dans lequel l'élément de blindage (140, 140A, 140B, 140C, 148, 162, 164) est serré entre la carte de circuit (130) et le boîtier (120), et la couche conductrice (142, 142A, 142B, 142C, 149) vient en contact avec le motif de base (132).

11. Appareil selon la revendication 10, dans lequel les premiers moyens de positionnement comprennent un élément en saillie et les deuxièmes moyens de positionnement comprennent un évidement coopérant.

12. Procédé de fabrication d'un élément de blindage (140, 140A, 140B, 140C, 148) selon l'une quelconque des revendications 1 à 9, à utiliser dans un appareil électronique contenu dans un boîtier (120), le boîtier (120) possédant des premiers moyens de positionnement (124), l'élément de blindage (140, 140A, 140B, 140C, 148) étant fixé à une carte de circuit (130) ayant un motif de base (132) et venant en contact avec le motif de base (132), caractérisé par les étapes consistant à :
déformer un élément en résine pour former des deuxièmes moyens de positionnement (144) destinés à venir en prise avec la partie de détermination des premiers moyens de positionnement (124) ; et
prévoir une couche conductrice (142, 142A, 142B, 142C, 149) à la surface de l'élément en résine déformé (146).

13. Procédé selon la revendication 12, caractérisé en outre en ce que l'étape de déformation est effectuée par moulage par injection.

14. Procédé de fabrication d'un élément de blindage (162, 164) selon l'une quelconque des revendications 1 à 9, à utiliser dans un appareil électronique contenu dans un boîtier (120), le boîtier (120) ayant des premiers moyens de positionnement (124), l'élément de blindage (162, 164) étant fixé à une carte de circuit (130) ayant un motif de base (132) et venant en contact avec le motif de base (132), caractérisé par les étapes consistant à :
déformer un élément conducteur (162, 164) de manière à ce que l'élément conducteur déformé (162, 164) ait des deuxièmes moyens de positionnement (144) couplés aux premiers moyens de positionnement (124) par un procédé de déformation plastique.
